# EUROPEAN PATENT APPLICATION

(11) **EP 2 690 520 A2**
(43) Date of publication of application: **29.01.2014**
(21) Application number: 13167025.9
(22) Date of filing: 08.05.2013
(51) Int. Cl.: G06F 1/16

(54) **Dampening mechanism and electronic device using same**

(30) Priority: 26.07.2012 CN 201210260890
(71) Applicant: Hon Hai Precision Industry Co., Ltd., New Taipei City (TW)
(72) Inventor: Chang, Hung-Chi, New Taipei (TW); Chang, Chia-Shou, New Taipei (TW); Peng, Yao-Che, New Taipei (TW)
(74) Representative: Gray, John James

(57) **Abstract**

An electronic device (100) includes a base (30), a cover (20) rotatably connected to the base (30) and a dampening mechanism (40a), (40b). The dampening mechanism (40a), (40b) includes an engaging component (60) secured to the base (30) and a dampening component (40) secured to the cover (20). When the cover (20) is opened, the engaging component (60) contacts with the dampening component (40a), (40b) for dampening the movement of the cover (20) relative to the base (30).

## Description

### Description of Related Art

Portable devices such as, disc players, notebook computers and mobile phones are ubiquitous. Each portable device may include a base, a cover, and a hinge for rotatably connecting the cover to the base, a latching mechanism for latching the cover to the base, and a torsion spring. The torsion spring is compressed when the cover is latched to the base, and rebounds to open the cover when the cover is unlatched from the base by operating the latching mechanism. However, the cover is prone to ricocheting/wobbling back and forth because of a force of the rebounded torsions spring, which causes damage to the devices.

Therefore, there is room for improvement in the art.

### Summary

According to an exemplary embodiment of the invention, an electronic device includes a base, a cover rotatably connected to the base, an engaging component secured to the base and a dampening component secured to the cover. The dampening component is capable of rotating along with the cover and contacting with the engaging component for dampening the movement of the cover relative to the base.

### BRIEF DESCRIPTION OF THE DRAWINGS

Embodiments of the invention will now be described, by way of example only, with reference to the accompanying drawings. Many aspects of the embodiments can be better understood with references to the following drawings. The components in the drawings are not necessarily drawn to scale, the emphasis instead being placed upon clearly illustrating the principles of the embodiments. Moreover, in the drawings, like reference numerals designate corresponding parts throughout two views.

FIG. 1 is a partial, isometric view of an electronic device with a dampening mechanism.

FIG. 2 is a similar to FIG. 1, but viewed from another aspect.

FIG. 3 is partial, isometric view of the dampening mechanism of FIG. 2.

FIG. 4 is another partial, isometric view of the dampening mechanism of FIG. 2.

FIG. 5 is a partial, isometric view of the electronic device of FIG. 2 in a first use state.

FIG. 6 is a partial, isometric view of the electronic device of FIG. 2 in a second use state.

FIG. 7 is a partial, isometric view of the electronic device of FIG. 2 in a third use state.

### DETAILED DESCRIPTION

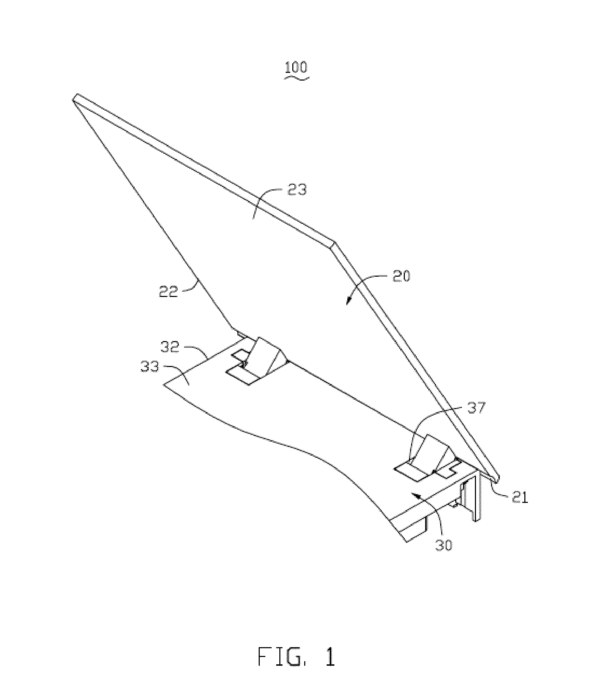

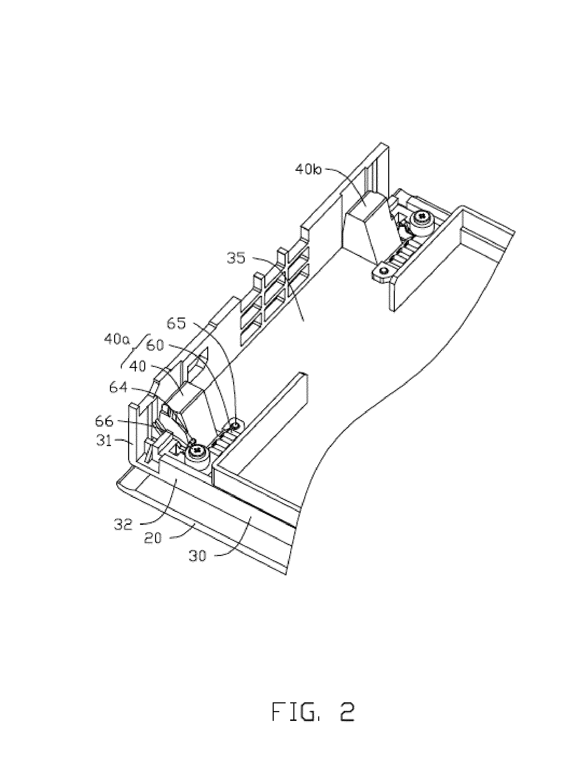

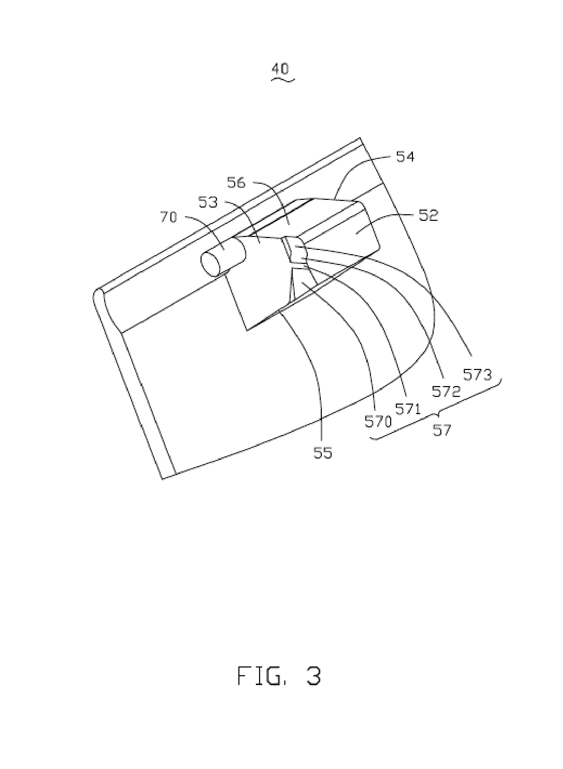

FIGS. 1 and 2 show an electronic device 100 of one embodiment. The electronic device 100 includes a cover 20, a base 30, a latching component (not shown) for latching the cover 20 to the base 30, two dampening mechanisms 40a, 40b and two pivots 70 for rotatably connecting the cover 20 to the base 30 (see FIG. 3). The base 30 is used for receiving electrical components of the electronic device 100, such as, a driving motor (not shown). The cover 20 is rotatably connected to the base 30 and is capable of is opened and closed relative to the base 30. The dampening mechanisms 40a, 40b are used for dampening the speed of the cover 20 when the cover 20 is unlatched from the base 30. The electronic device 100 may be a disc player, a notebook computer or a mobile phone. In the embodiment, the electronic device 100 is a notebook computer.

The cover 20 is substantially rectangle. The cover 20 includes a first sidewall 21, a second sidewall 22 connected to the first sidewall 21, a first surface 23, and a second surface (not labeled) opposite to the first surface 23. When the cover 20 is closed to the base 30, the first surface 23 faces the base 30.

The base 30 includes a third sidewall 31, a fourth sidewall 32, an outer surface 33, and an inner surface 35 opposite to the outer surface 33. The third sidewall 31 corresponds to the first sidewall 21. The fourth sidewall 32 is perpendicularly connected to the third sidewall 31 and corresponds to the second sidewall 22. The outer surface 33 faces the first surface 23 when the cover 20 covers the base 10. Two mounting holes 37 are defined at an end of the outer surface 33 adjacent to the third sidewall 31, and are spaced apart from each other.

Two dampening mechanisms 40a, 40b are arranged between two corresponding ends of the cover 20 and the base 30 near the first and second sidewalls 21, 31. The configurations of the two dampening mechanisms 40a, 40b are the same. For simplicity, only the dampening mechanism 40a adjacent to the fourth sidewall 32 is descried as follow.

The dampening mechanism 40a includes a dampening component 40 and an engaging component 60. The dampening component 40 protrudes out of the first surface 23. The dampening component 40 is arranged adjacent to the first sidewall 21 corresponding to the mounting hole 37 adjacent to the fourth sidewall 32.

FIG. 3 shows that the dampening component 40 includes an upper surface 52 and four sidewalls (hereinafter, a first side surface 53 opposite to the dampening mechanism 40b, a second side surface 54 opposite to the first side surface 53, a third side surface 55 and a fourth side surface 56 opposite to the third side surface 55) connected between the first surface 23 and the upper surface 52. The upper surface 52 is opposite and parallel to the first surface 23.

A first dampening portion 570 is defined on the first side surface 53 and is arranged adjacent to the upper surface 52. The first dampening portion 570 extends from the third side surface 55 to the fourth side surface 56 and creates a small void in a portion of the first side surface 53 adjacent to the upper surface 52. The first dampening portion 570 is an inclined surface. The distance between an end of the first dampening portion 570 adjacent to the third side surface 55 and the second side surface 54 is less than the distance between an end of the first dampening portion 570 adjacent to the fourth side surface 56 and the second side surface 54.

An end of the first side surface 53 opposite to the first dampening portion 570 is cut away to form a positioning portion 573. The positioning portion 573 and the first dampening portion 570 are aligned parallel with the first surface 23. The positioning portion 573 is spaced apart from the first dampening portion 570. The positioning portion 573 extends from the fourth side surface 56 to the third side surface 55 and creates a small void in a portion of the first side surface 53 adjacent to the upper surface 52.

A second dampening portion 571 is arranged between the first dampening portion 570 and the positioning portion 573. The second dampening portion 571 is parallel to the first side surface 53. In the embodiment, the second dampening portion 571 is coplanar with the first side surface 53.

A guiding portion 572 is arranged between the second dampening portion 571 and the positioning portion 573. The guiding portion 572 slantingly extends from an edge of the positioning portion 573 adjacent to the second dampening portion 571 in a direction away from the second dampening portion 571, for communicating the second dampening portion 571 with the positioning portion 573. In the embodiment, the boundaries between the second dampening portion 571 and the first dampening portion 570 or the guiding portion 572 are substantially smooth.

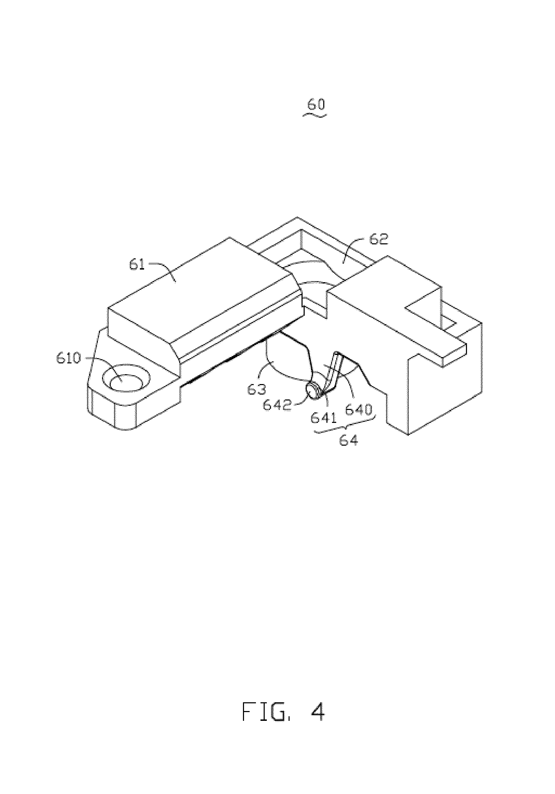

FIG. 4 shows that the engaging component 60 is mounted on the inner surface 35 of the base 30 and is placed around the mounting hole 73 adjacent to the fourth sidewall 32. The engaging component 60 is substantially L-shaped, and includes a first fixing portion 61, a second fixing portion 62, a positioning post 63 and a resisting arm 64.

The first fixing portion 61 and the second fixing portion 62 are substantially strip-shaped. The first fixing portion 61 and the second fixing portion 62 are perpendicularly connected to each other. A positioning hole 610 is defined at an end of the first fixing portion 61 opposite to the second fixing portion 62. The positioning post 63 protrudes from an end of the second fixing portion 62 adjacent to the first fixing portion 61.

The resisting arm 64 protrudes from the second fixing portion 62 and extends in the same direction of the positioning post 63. The resisting arm 64 includes a connecting portion 640 and a contacting portion 641 connected to the connecting portion 640. The connecting portion 640 protrudes from a rim of the second fixing portion 62 connected to the first fixing portion 61. The contacting portion 641 is substantially column shaped, and protrudes from a surface of the connecting portion 640 opposite to the first fixing portion 61. The contacting portion 641 includes a contacting surface 642 for contacting with the dampening component 40. In the embodiment, the contacting surface 642 is a planar surface. The protruding direction of the contacting portion 641 is the same as the extending direction of the first fixing portion 61 relative to the second fixing portion 62.

Each pivot 70 protrudes from an end of the first side surface 53 adjacent to the lower surface 51. A pivoting hole (not shown) is defined at the base 30 for engaging with the corresponding pivot 70, thus, the cover 20 is capable of being rotated about the base 30 around the pivots 70. In other embodiment, the pivots 70 and the dampening components 40 can be separately mounted on the cover 20 and/or the base 30.

FIG. 2 further shows that in assembly, the dampening component 40 extends through the mounting hole 73, with the pivot 70 being received in the pivot hole and the first side surface 53 facing the fourth sidewall 32. In this state, the cover 20 is capable of being rotated about the base 30 via the pivots 70.

The engaging component 60 is mounted on the inner surface 35 and is placed around the mounting hole 73. A first latching component 65 engages with the positioning hole 610, and a second latching component 66 engages with the positioning post 63, for cooperatively fixing the engaging component 60 to the inner surface 35. In this state, the first fixing portion 61 is positioned on an end of the mounting hole 73 opposite to the third sidewall 31. The second fixing portion 62 is positioned on an end of the mounting hole 73 opposite to the first side surface 53, with the contacting portion 641 facing the first side surface 53, for allowing the contacting portion 641 to engage with the dampening component 40a.

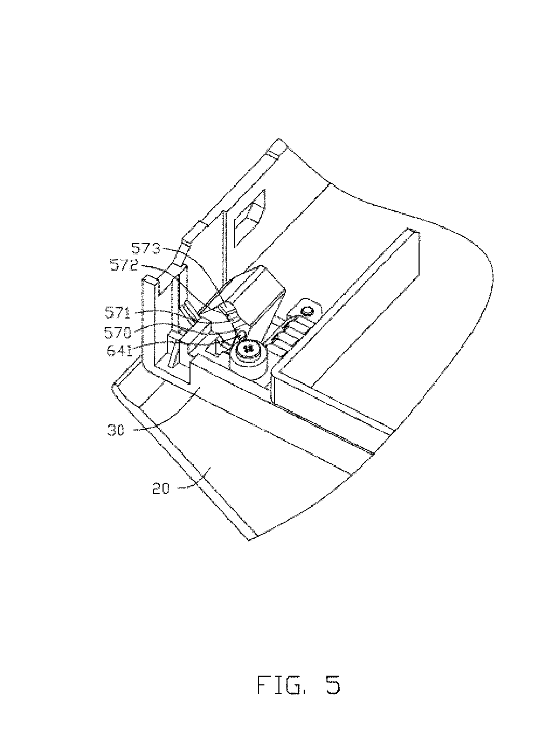

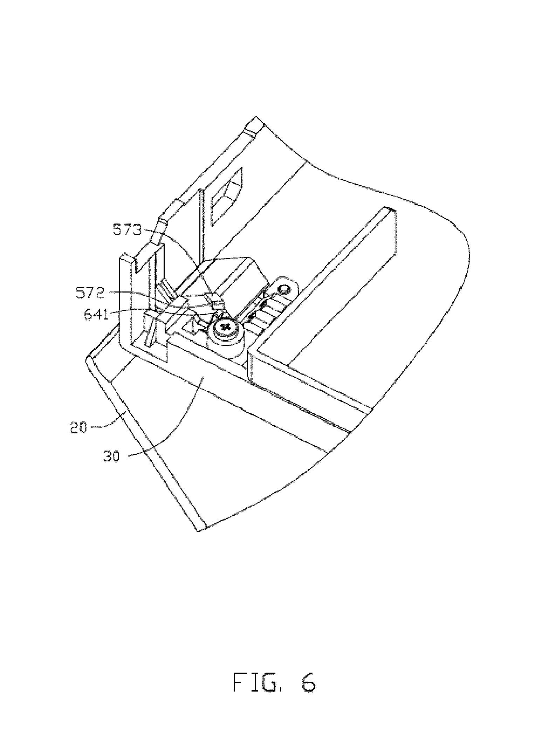

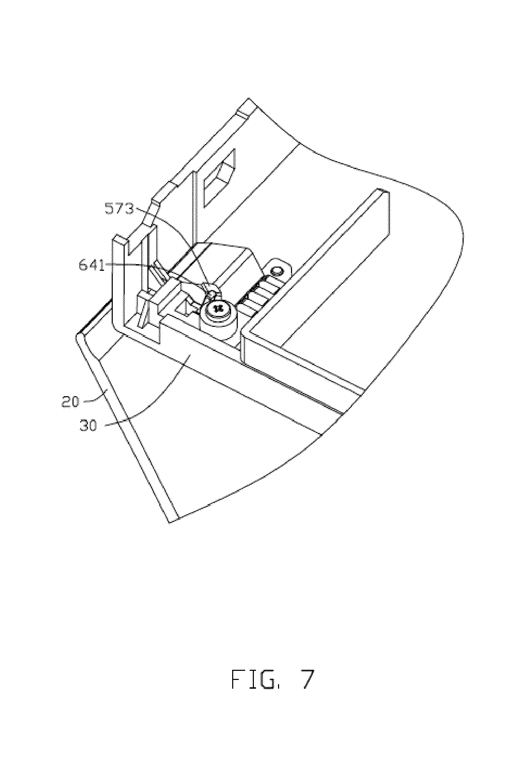

FIGS. 5, 6 and 7 show that when the cover 20 is opened, the cover 20 rotates around the pivot 70 and drives the dampening component 40 to be rotated relative to the engaging component 60. The contacting portion 641 first contacts with the first dampening portion 570, and then slides to the second dampening portion 571 along the first dampening portion 570. The first dampening portion 570 is an upwardly slanted surface, slanted relative to the contacting portion 641. The contacting surface 642 is a planar surface. When the contacting portion 641 slides along the first dampening portion 570, a portion of the contacting surface 642 contacts with the first dampening portion 570. Thus, the friction between the contacting portion 641 and the first dampening portion 570 is small, and the cover 20 is dampened relative to the base 30 slowly and steadily. Then, because the surface of the second dampening portion 571 and the contacting surface 642 are planar surfaces, when the contacting portion 641 slides to and resists the second dampening portion 571, the whole of the contacting surface 642 contacts with the second dampening portion 571. In addition, a maximum contact area and friction between the contacting surface 642 and the first dampening portion 570 occurs. Thus, the cover 20 is further dampened by the dampening component 40 quickly and approaches a stopped position. Finally, an external force in a direction away from the base 30 is applied to the cover 20, the contacting portion 641 slides to the positioning portion 573 along the guiding portion 572 and is locked into the positioning portion 573. In other embodiments, the engaging manner between the contacting portion 641 and the positioning portion 573 can be changed according to need. For example, when the contacting portion 641 slides to an end of the second dampening portion 571 opposite to the first dampening portion 570, the cover 20 is capable of sliding to the positioning portion 573 automatically by the guiding portion 572.

In the embodiment, when the cover 20 is opened, the contacting portion 641 first contacts with the first dampening portion 570 to dampen the speed of the cover 20 relative to the base 30 at the beginning. Then, the contacting portion 641 contacts with the second dampening portion 571 to further dampen the speed of the cover 20 relative to the base 30 until the cover 20 approaches a stopped position relative to the base 30. Finally, the engaging component 60 is locked to the positioning portion 573 for positioning the cover 20 relative to the base 30. Thus, the cover 20 is capable of is opened steadily. The position of the dampening component 40 and the engaging portion 60 can be changed according to need. For example, the dampening component 40 is arranged on the base 30, and the engaging component 60 is arranged on the cover 20. The inclined directions and angles of the first dampening portion 570 and the guiding portion 572 also can be changed according to the need.

It is to be understood, however, that even though information and advantages of the present embodiments have been set forth in the foregoing description, together with details of the structures and functions of the present embodiments, the disclosure is illustrative only; and that changes may be made in detail, especially in the matters of shape, size, and arrangement of parts within the principles of the present embodiments to the full extent indicated by the broad general meaning of the terms in which the appended claims are expressed.

## Claims

1. An electronic device, comprising:
a base;
a cover rotatably connected to the base; and
a dampening mechanism arranged between the base and the cover, the dampening mechanism comprising:
an engaging component secured to the base; and
a dampening component secured to the cover and capable of rotating relative to the base when the cover rotates relative to the base;
wherein when the cover is opened, the engaging component contacts with the dampening component for dampening the cover relative to the base.

2. The electronic device of claim 1, wherein when the cover is opened, a portion of the engaging component firstly contacts with the dampening component, and then the whole of the engaging component contacts with the dampening component, for allowing friction between the engaging component and the dampening component to become larger.

3. The electronic device of claim 1 or 2, wherein the dampening component comprises a first dampening portion, the first dampening portion is an inclined surface and is upwardly slanted relative to the engaging component; when the cover is opened, a portion of the engaging component contacts with the first dampening portion for dampening the movement of the cover relative to the base.

4. The electronic device of claim 3, wherein the dampening component comprises a second dampening portion connected to the first dampening portion; when the cover is opened, the engaging component moves from the first dampening portion to the second dampening portion.

5. The electronic device of claim 4, wherein the second dampening portion is a planar surface connected to the first dampening portion; when the cover is opened, the whole of the engaging component contacts with the second dampening portion for dampening the movement of the cover relative to the base.

6. The electronic device of claim 4 or 5, wherein the engaging component comprises a contacting portion, the contacting portion comprises a contacting surface opposite to the dampening component; the contacting surface is a planar surface parallel to the second dampening portion; when the contacting portion moving along the first dampening portion, a portion of the contacting surface contacts with the first dampening portion; when the contacting portion moves along the second dampening portion, the whole of the contacting surface contacts with the second dampening portion.

7. The electronic device of claim 4, 5 or 6, wherein the dampening component comprises a positioning portion, the positioning portion and the first dampening portion are arranged on opposite sides of the second dampening portion; when the cover is opened, the engaging component is capable of being locked to the positioning portion.

8. The electronic device of claim 7, wherein the dampening component comprises a guiding portion arranged between the second dampening portion and the positioning portion, the guiding portion slantingly extends from the second dampening portion to the positioning portion.

9. A dampening mechanism for dampening a cover of an electronic device, the electronic device further comprising a base, the cover rotatably connected to the base; the dampening mechanism comprising:
an engaging component secured to the base; and
a dampening component secured to the cover and capable of pivoting about the base when the cover rotates relative to the base;
wherein when the cover is opened, the engaging component contacts with the dampening component for dampening the cover relative to the base.

10. The dampening mechanism of claim 9, wherein when the cover is opened, a portion of the engaging component contacts with the dampening component, and then the whole of the engaging component contacts with the dampening component, for allowing friction between the engaging component and the dampening component to become larger.

11. The dampening mechanism of claim 9 or 10, wherein the dampening component comprises a first dampening portion, the first dampening portion is an inclined surface and is upwardly slanted relative to the engaging component; when the cover is opened, the engaging component contacts with the first dampening portion for dampening the movement of the cover relative to the base.

12. The dampening mechanism of claim 11, wherein the dampening component comprises a second dampening portion connected to the first dampening portion; the second dampening portion is a planar surface connected to the first dampening portion; when the cover is opened, the whole of the engaging component contacts with the second dampening portion for dampening the movement of the cover relative to the base.

13. The dampening mechanism of claim 12, wherein the engaging component comprises a contacting portion, the contacting portion comprises a contacting surface opposite to the dampening component; the contacting surface is a planar surface parallel to the second dampening portion; when the contacting portion moves along the first dampening portion, a portion of the contacting surface contacts with the first dampening portion; when the contacting portion moves along the second dampening portion, the whole of the contacting surface contacts with the second dampening portion.

14. The dampening mechanism of claim 12 or 13, wherein the dampening component comprises a positioning portion, the positioning portion and the first dampening portion are arranged on opposite sides of the second dampening portion; when the cover is opened, the engaging component is capable of being locked to the positioning portion.

15. The dampening mechanism of claim 14, wherein the dampening component comprises a guiding portion arranged between the second dampening portion and the positioning portion, the guiding portion slantingly extends from the second dampening portion to the positioning portion.
